**Europäisches Patentamt**

**European Patent Office**

**Office européen des brevets**

(19)

(11) Veröffentlichungsnummer: **0 162 316**
**A2**

(12) ## EUROPÄISCHE PATENTANMELDUNG

(21) Anmeldenummer: 85104929.6

(22) Anmeldetag: 23.04.85

(51) Int. Cl.⁴: **G 03 F 7/20**
**G 03 F 7/26, G 03 F 7/02**

(30) Priorität: 21.05.84 DE 3418856

(43) Veröffentlichungstag der Anmeldung:
27.11.85 Patentblatt 85/48

(84) Benannte Vertragsstaaten:
CH DE FR GB LI NL

(71) Anmelder: ERNST LEITZ WETZLAR GMBH
Ernst-Leitz-Strasse 30 Postfach 20 20
D-6330 Wetzlar 1(DE)

(72) Erfinder: Heitmann, Knut, Dipl.-Ing.
Lerchenweg 16
D-6330 Wetzlar(DE)

(72) Erfinder: Hoppe, Martin, Dr. Dipl.-Min.
Helgebachstrasse 29
D-6330 Wetzlar(DE)

(72) Erfinder: Schneider, Eckhard
Lauerstrasse 3
D-6330 Wetzlar(DE)

(72) Erfinder: Thaer, Andreas, Dr. rer. nat.
Steinweg 8
D-6301 Leihgestern(DE)

(54) Verfahren zur Beeinflussung von Strukturprofilen in Resistschichten.

(57) Ein Verfahren zur Beeinflussung von Strukturprofilen, die durch Polymerisation bzw. Depolymerisation in Resistschichten erzeugt werden, zeichnet sich dadurch aus, daß in Abhängigkeit von der akustischen Impedanz des die Resistschicht tragenden Substrats zur Verstärkung des Kontrastes die Strukturen mit einem Ultraschallstrahlenbündel beschallt werden, für dessen Frequenz das Substrat eine hohe Impedanz darstellt, und zur Schwächung des Kontrasts die Strukturen mit einem Ultraschallstrahlenbündel beschallt werden, für dessen Frequenz das Substrat eine niedrige Impedanz darstellt.

Für die Durchführung des Verfahrens ist ein akustisches Mikroskop besonders geeignet.

Croydon Printing Company Ltd.

Verfahren zur Beeinflussung von
Strukturprofilen in Resistschichten

Die Erfindung betrifft ein Verfahren zur Beeinflussung
von Strukturprofilen, die durch Polymerisation bzw.
Depolymerisation in Resistschichten erzeugt werden.

Unter einem Resist soll hier eine Masse verstanden werden, die auf einer Substratoberfläche aufgebracht werden kann, um den von ihr bedeckten Teil zu maskieren, d.h. dem Angriff von z.B. Ätzmitteln, chemischen oder galvanischen Metallisierungsbädern usw. zu entziehen. Resiste, wie z.B. Fotolacke, haben die Eigenschaft, daß sich ihre Löslichkeit durch Belichtung mit UV-, Elektronen-, Röntgen- oder Ionenstrahlen ändert. Dabei kommt es entweder zur Bildung von Polymeren und deren Vernetzung (sog. Negativschichten) oder zum Aufbrechen von Polymeren und Überführen in niedermolekulare lösliche Verbindungen (sog. Positivschichten). Die Eigenschaft der Löslichkeitsänderung in den bestrahlten bzw. nicht bestrahlten Flächenbereichen wird ausgenutzt, um durch nachfolgende chemische Entwicklungsprozesse ein Auswaschrelief auf der Substratoberfläche zu erzeugen. Das Strukturprofil dieses Auswaschreliefs hängt z.B. von dem Material des Resists, der Schichtdicke, der Dauer der Bestrahlung und der Intensität der für die Bestrahlung gewählten elektro-magnetischen Wellen und auch von den chemischen Entwicklungs- und Fixierungsprozessen ab. Während die materialbedingten Einflüsse weitgehend kontrolliert werden können, besteht eine Unsicherheit über den jeweils erreichten Grad der der Vernetzung bzw. Fragmentierung der Polymere, da diese mit den bekannten Verfahren erst nach der chemischen Entwicklung sichtbar werden. Dann ist es für etwaige Korrekturen jedoch zu spät.

Es ist nun gefunden worden, daß eine mit den bekannten lithographischen Verfahren in einer Resistschicht induzierte Vernetzung bzw. Fragmentierung durch Einstrahlung von Ultraschall beschleunigt und vor allem auch fortgeführt werden kann (vgl. DE-Patentanmeldung P

). Der Erfindung liegt die Aufgabe zugrunde, dieses Verfahren in der Weise weiterzuentwicklen, daß nicht nur der lithographisch induzierte Prozeß durch Ultraschalleinstrahlung zu Ende geführt werden kann, sondern eine reversible Manipulation des Strukturprofils in der Resistschicht an den lithographisch beaufschlagten Stellen möglich wird.

Diese Aufgabe wird bei einem Verfahren der eingangs genannten Art erfindungsgemäß durch die kennzeichnenden Merkmale des Anspruchs 1 gelöst. Vorteilhafte Weiterbildungen ergeben sich durch die Unteransprüche 2 bis 5.

Der Erfindung liegt die Erkenntnis zugrunde, daß die durch ein akustisches Ankopplungsmedium in die Resistschicht eindringenden Ultraschallwellen die vorbelichtete Polymerstruktur des Resists in Abhängigkeit von der akustischen Impedanz des darunter befindlichen Substrats unterschiedlich beeinflussen. Eine hohe akustische Impedanz des Substrats führte zu einer Verstärkung des Kontrastes im akustischen Bild der vernetzten bzw. fraktionierten Struktur im Resist, d.h. einer Linienverbreiterung und eine niedrige Impedanz zu einer Schwächung des Kontrastes, die bis zur Auslöschung der Struktur führen konnte. Da die akustische Impedanz von der eingestrahlten Ultraschallfrequenz abhängt, kann durch Wahl geeigneter Ultraschallfrequenzen bei vorgegebenem Substrat das Strukturprofil im Resist in der jeweils gewünschten Weise beeinflußt werden.

Dem beschriebenen Effekt kann bereits bei der Herstellung der Resistbeschichtung Rechnung getragen werden, indem auf das Substrat zunächst eine Zwischenschicht aufgebracht wird, deren akustische Impedanz nur für ausgewählte Ultraschallfrequenzen angepaßt ist. Unter Anpassung der akustischen Impedanz soll neben der frequenzmäßigen Anpassung des Materials der Zwischenschicht vor allem auch eine Schichtdickenanpassung an die akustische Weglänge in diesem Material verstanden werden, so daß die Zwischenschicht als Antireflexbelegung für akustische Wellen wirkt. In besonderen Anwen-

- 4 -

dungsfällen sollte die Zwischenschicht optisch transparent sein. Das ist vor allem bei solchen Objekten von Bedeutung, bei denen das Endprodukt nach der Entwicklung der Resitschicht optisch transparent sein soll. Wenn z.B. als Substrat ein Saphirplättchen gewählt wird, kann als Zwischenschicht z.B. eine $\lambda/4$-Glasschicht aufgebracht werden. Die ausgewählten Ultraschallfrequenzen, für die die Anpassung gilt, werden dann zur Schwächung des Kontrastes des Strukturprofils in der Resistschicht verwendet. Für die Wahl der kontrastverstärkenden Ultraschallfrequenzen besteht dann eine größere Freiheit.

Für die Herstellung von Beugungsgittern ist es häufig erwünscht, wenn das Strukturprofil in der Resistschicht auch in der dritten Dimension beeinflußt werden kann, um in der entwickelten Resistschicht z.B. eine sinusförmige Phasenstruktur oder eine Struktur mit einem bestimmten Blazewinkel erzeugen zu können. Für diesen Anwendungszweck kann die Beschallung mit einem Ultraschallstrahlenbündel erfolgen, für dessen Frequenz die unter der Resistschicht befindliche Schicht eine hohe Impedanz darstellt und für dessen Wellenlänge in der Resistschicht stehende Wellen erzeugt werden. Der lithographische Prozeß braucht bei diesem Verfahren lediglich die Gitterkonstante festzulegen, die Gitterform wird z.B. durch die Richtung der Ultrabeschallung erzeugt, in der sich stehende Wellen in der Resistschicht ausbilden.

Zur Beschallung eignet sich insbesondere eine in der Frequenz abstimmbare akustische Linsenanordnung. Vorzugsweise kann ein akustisches Mikroskop verwendet werden, mit dem gleichzeitig das jeweils erreichte Strukturprofil sichtbar dargestellt werden kann.

# Ansprüche

1. Verfahren zur Beeinflussung von Strukturprofilen, die durch Polymerisation bzw. Depolymerisation in Resistschichten erzeugt werden, d a d u r c h g e k e n n z e i c h n e t , daß in Abhängigkeit von der akustischen Impedanz des die Resistschicht tragenden Substrats zur Verstärkung des Kontrastes die Strukturen mit einem Ultraschallstrahlenbündel beschallt werden, für dessen Frequenz das Substrat eine hohe Impedanz darstellt, und zur Schwächung des Kontrasts die Strukturen mit einem Ultraschallstrahlenbündel beschallt werden, für dessen Frequenz das Substrat eine niedrige Impedanz darstellt.

2. Verfahren nach Anspruch 1, d a d u r c h g e - k e n n z e i c h n e t , daß unter der Resistschicht eine Zwischenschicht eingefügt wird, deren akustische Impedanz nur für ausgewählte Ultraschallfrequenzen angepaßt ist, und diese Frequenzen zur Schwächung des Kontrastes eines Strukturprofils in der Resistschicht verwendet werden.

3. Verfahren nach Anspruch 1, d a d u r c h  g e -
k e n n z e i c h n e t ,  daß die Beschallung mit
einem Ultraschallstrahlenbündel erfolgt, für dessen
Frequenz die unter der Resistschicht befindliche
Schicht eine hohe Impedanz darstellt und für dessen
Wellenlänge in der Resistschicht stehende Wellen erzeugt werden.

4. Verfahren nach einem der vorhergehenden Ansprüche,
d a d u r c h  g e k e n n z e i c h n e t ,  daß
zur Beschallung eine in der Frequenz abstimmbare
akustische Linsenanordnung verwendet wird.

5. Verfahren nach einem der vorhergehenden Ansprüche,
d a d u r c h  g e k e n n z e i c h n e t ,  daß
zur Beschallung und Darstellung des jeweils erzeugten Strukturprofils ein akustisches Mikroskop verwendet wird.